# EUROPEAN PATENT APPLICATION

(11) **EP 3 001 453 A1**
(43) Date of publication of application: **30.03.2016**
(21) Application number: 15184336.4
(22) Date of filing: 08.09.2015
(51) Int. Cl.: H01L 23/495

(54) **SEMICONDUCTOR DEVICE**

(30) Priority: 29.09.2014 JP 2014198819
(71) Applicant: Renesas Electronics Corporation, Tokyo 135-0061 (JP)
(72) Inventor: TABIRA, Yukinori, Koutou-ku, Tokyo 135-0061 (JP); KOIKE, Nobuya, Koutou-ku, Tokyo 135-0061 (JP); KIYOHARA, Toshinori, Koutou-ku, Tokyo 135-0061 (JP)
(74) Representative: Moore, Graeme Patrick

(57) **Abstract**

To reduce a mounting area while securing a mounting strength of a semiconductor device, a power transistor includes a chip mounting portion, a semiconductor chip, a plurality of leads, and a sealing body. An outer lead portion in each of the plurality of leads includes a first portion protruding from a second side surface of the sealing body in a first direction, a second portion extending in a second direction intersecting with the first direction, and a third portion extending in a third direction intersecting with the second direction. Furthermore, a length of the third portion in the third direction of the outer lead portion is shorter than a length of the first portion in the first direction.

## Description

### TECHNICAL FIELD OF THE INVENTION

The present invention relates to a semiconductor device and relates to an effective technique applied to, for example, a semiconductor device including a lead protruding from a side surface of a sealing body for sealing a semiconductor chip.

### BACKGROUND OF THE INVENTION

In a resin-sealed semiconductor device (package), a reduction in a mounting area of a package has recently been required.

Here, in a semiconductor device including a sealing resin layer for sealing a semiconductor chip, a structure in which an outer lead protruding from the side surface of the sealing resin layer is bent and a structure for solder mounting to a substrate are disclosed in, for example, Japanese Patent Application Laid-Open No. H5(1993)-36863 (Patent Document 1).

In addition, in a semiconductor device including a sealing body, a structure in which a lead protruding from the sealing body is bent and a structure for soldering to a substrate are disclosed in, for example, Japanese Patent Application Laid-Open No. H5 (1993)-21683 (Patent Document 2).

Furthermore, in a resin-sealed semiconductor device, a QFP structure in which a lead is disposed on each of four sides of a sealing body is disclosed in, for example, Japanese Patent Application Laid-Open No. 2013-183054 (Patent Document 3).

### SUMMARY OF THE INVENTION

In the semiconductor device, a reduction in a lead length may be considered so as to cope with a narrow pitch and a reduced mounting area. However, when the lead length is reduced, a soldering area of the lead to a mounting substrate is reduced. Thus, there is a concern about a reduction of a mounting strength.

That is, when the lead length is reduced, it is difficult to secure the mounting strength.

Therefore, the inventors of the present invention have studied a technique that can secure a mounting strength in a structure of a semiconductor device in which a lead length is reduced.

The other problems and novel characteristics of the present invention will be apparent from the description of the present specification and the accompanying drawings.

A semiconductor device according to an embodiment includes a chip mounting portion, a semiconductor chip, a lead, and a sealing body. The other part of the chip mounting portion protrudes from a first side surface of the sealing body. Further, an outer lead portion of the lead includes a first portion protruding from a second side surface of the sealing body in a first direction, a second portion extending in a second direction intersecting with the first direction, and a third portion extending in a third direction intersecting with the second direction. A length of the third portion in the third direction is shorter than a length of the first portion in the first direction.

Further, a semiconductor device according to an embodiment includes a chip mounting portion, a semiconductor chip, a lead, and a sealing body. The other part of the chip mounting portion protrudes from a first side surface of the sealing body. Further, the outer lead portion of the lead includes a first portion, a second portion, and a third portion. Furthermore, the first portion of the outer lead portion has a first front end surface connected to a second side surface of the sealing body, the second portion of the outer lead portion is disposed between the first portion and the third portion, and the third portion of the outer lead portion has a second front end surface disposed on an opposite side of the first front end surface. Furthermore, a length from a first intersecting portion between a first virtual line of the first portion and the first front end surface to a second intersecting portion between an extension line of the first virtual line of the first portion and an extension line of a second virtual line of the second portion is longer than a length from a third intersecting portion between an extension line of a third virtual line of the third portion and an extension line of the second virtual line of the second portion to a fourth intersecting portion between the third virtual line of the third portion and the second front end surface. Furthermore, the first virtual line is a line that passes through a center of the first portion in a thickness direction and extends in parallel to a surface of the first portion, the second virtual line is a line that passes through a center of the second portion in a thickness direction and extends in parallel to a surface of the second portion, and the third virtual line is a line that passes through a center of the third portion in a thickness direction and extends in parallel to a surface of the third portion.

According to the embodiment, it is possible to reduce a mounting area while securing a mounting strength of a semiconductor device.

### BRIEF DESCRIPTIONS OF THE DRAWINGS

FIG. 1 is a plan view illustrating an example of a structure of a semiconductor device of an embodiment of the present invention;
FIG. 2 is an arrow view seen from a direction A illustrated in FIG. 1;
FIG. 3 is a rear view illustrating an example of a structure of a rear surface side of the semiconductor device illustrated in FIG. 1;
FIG. 4 is a transparent plan view transparently illustrating a structure of an inside of the semiconductor device illustrated in FIG. 1;
FIG. 5 is a cross-sectional view illustrating an example of a structure cut out along the line A-A of FIG. 4;
FIG. 6 is a cross-sectional view and a partial enlarged cross-sectional view illustrating an example of a structure cut out along the line B-B of FIG. 4;
FIG. 7 is a schematic diagram illustrating a definition of a lead shape of the semiconductor device of the embodiment;
FIG. 8 is a schematic diagram illustrating another definition of the lead shape of the semiconductor device of the embodiment;
FIG. 9 is a plan view illustrating an example of a land pattern in a mounting substrate on which the semiconductor device of the present embodiment is mounted;
FIG. 10 is a plan view illustrating an example of a structure in which the semiconductor device of the embodiment is mounted on the land pattern illustrated in FIG. 9;
FIG. 11 is a side view illustrating an example of a mounting structure of FIG. 10;
FIG. 12 is a comparison diagram illustrating a lead shape of the semiconductor device of the embodiment and a lead shape of the semiconductor device of the comparative example;
FIG. 13 is an external comparison diagram illustrating an example of each dimension of the semiconductor device of the embodiment and the semiconductor device of the comparative example;
FIG. 14 is a data diagram illustrating an example of each dimension illustrated in FIG. 13;
FIG. 15 is a comparison diagram of an aspect ratio of the lead in the semiconductor device of the embodiment and the semiconductor device of the comparative example;
FIG. 16 is a comparison diagram illustrating the effects by a comparison between the semiconductor device of the embodiment and the semiconductor device of the comparative example;
FIG. 17 is a test condition diagram illustrating an example of a method of testing a mounting strength in the semiconductor device of the embodiment;
FIG. 18 is a data diagram illustrating test results of the mounting strength in the semiconductor device of the embodiment and the semiconductor device of the comparative example;
FIG. 19 is a flow diagram illustrating a procedure of assembling the semiconductor device of the embodiment;
FIG. 20 is a plan view illustrating an example of a main process in the assembling of the semiconductor device of the embodiment;
FIG. 21 is a plan view illustrating an example of a main process in the assembling of the semiconductor device of the embodiment;
FIG. 22 is a plan view and a side view illustrating an example of a main process in the assembling of the semiconductor device of the embodiment;
FIG. 23 is a plan view illustrating an example of a main process in the assembling of the semiconductor device of the embodiment;
FIG. 24 is a plan view illustrating an example of a main process in the assembling of the semiconductor device of the embodiment;
FIG. 25 is a plan view and a cross-sectional view illustrating an example of a main process in the assembling of the semiconductor device of the embodiment;
FIG. 26 is a partial cross-sectional view illustrating a structure after a first lead cut in a lead cut of the assembling of the semiconductor device of the embodiment;
FIG. 27 is a partial cross-sectional view illustrating a structure after a second lead cut in the lead cut of the assembling of the semiconductor device of the embodiment;
FIG. 28 is a perspective view illustrating an example of a structure of a mechanically and electrically integrated module of an embodiment;
FIG. 29 is a plan view illustrating an example of an internal structure of an inverter unit in the mechanically and electrically integrated module of FIG. 28;
FIG. 30 is a circuit block diagram illustrating an example of a circuit configuration of the mechanically and electrically integrated module of FIG. 28;
FIG. 31 is a plan view illustrating a structure of a semiconductor device of a modification example of the embodiment; and
FIG. 32 is a cross-sectional view illustrating a structure cut out along the line A-A of FIG. 31.

### DESCRIPTIONS OF THE PREFERRED EMBODIMENTS

The description of the same or similar portions is not repeated in principle unless particularly required in the following embodiments.

Further, in the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Furthermore, in the embodiments described below, when referring to the number of elements (including number of pieces, values, amount, range, and the like), the number of the elements is not limited to a specific number unless otherwise stated or except the case where the number is apparently limited to a specific number in principle.

Furthermore, in the embodiments described below, it goes without saying that the components (including element steps) are not always indispensable unless otherwise stated or except the case where the components are apparently indispensable in principle.

Furthermore, as for the components in the embodiments below, it is obvious that expressions "composed of A", "made up of A", "having A", and "including A" do not exclude elements other than an element A, except a case where these expressions are defined as expressions that refer exclusively to the sole element A. Similarly, in the embodiments described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

Hereinafter, an embodiment of the present invention will be described with reference to the drawings. Note that components having the same function are denoted by the same reference symbols throughout the drawings for describing the embodiments, and the repetitive description thereof is omitted. Moreover, in some drawings for describing in the embodiments, hatching is used even in a plan view so as to make the drawings easy to see.

### (Embodiment)

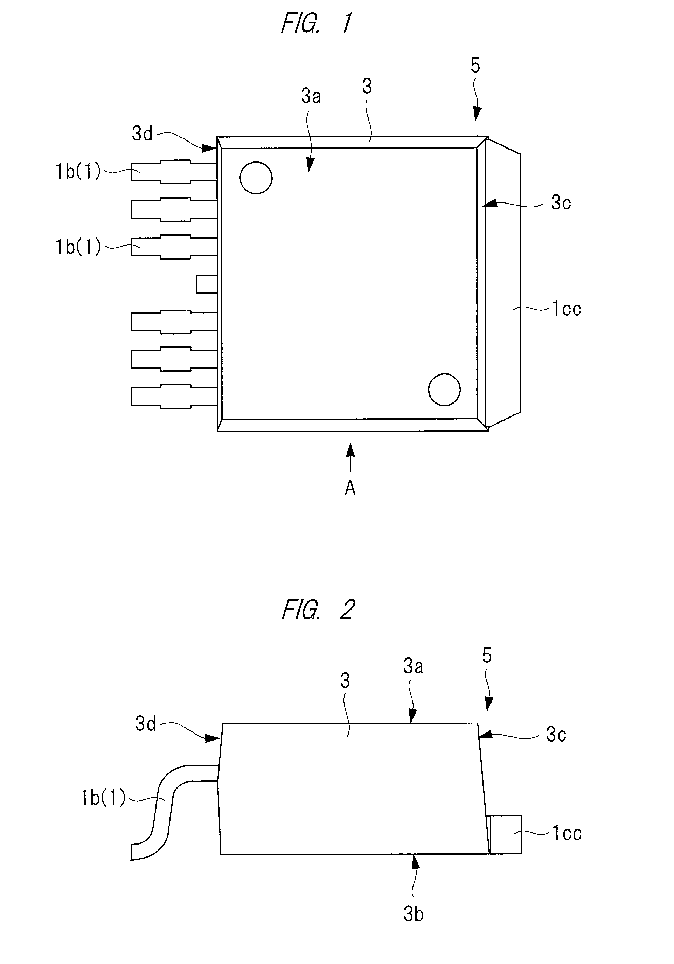

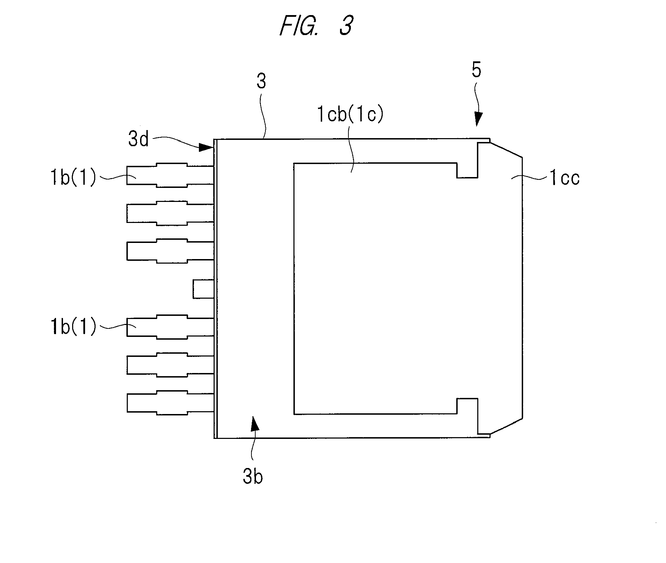

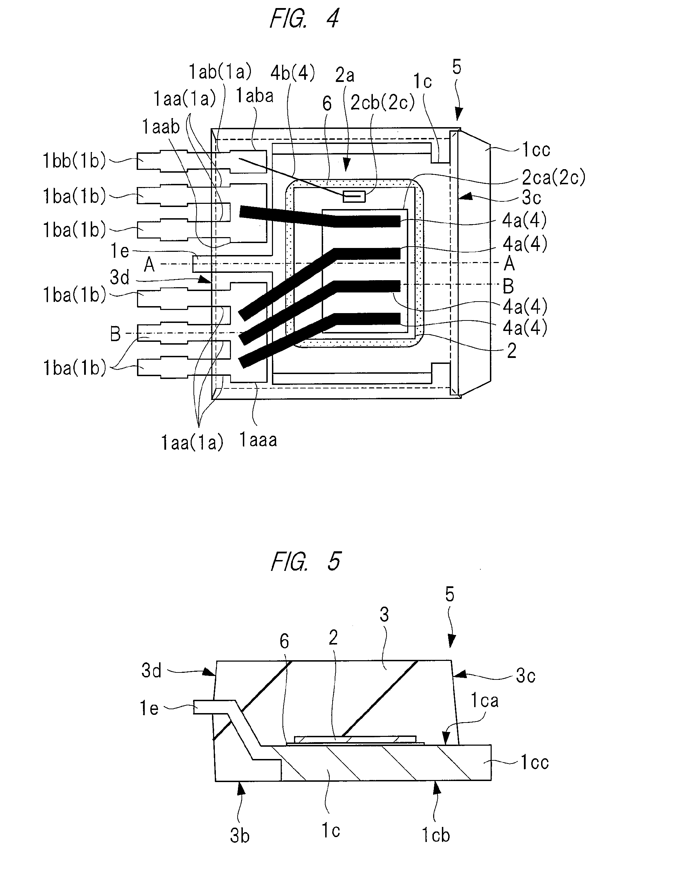

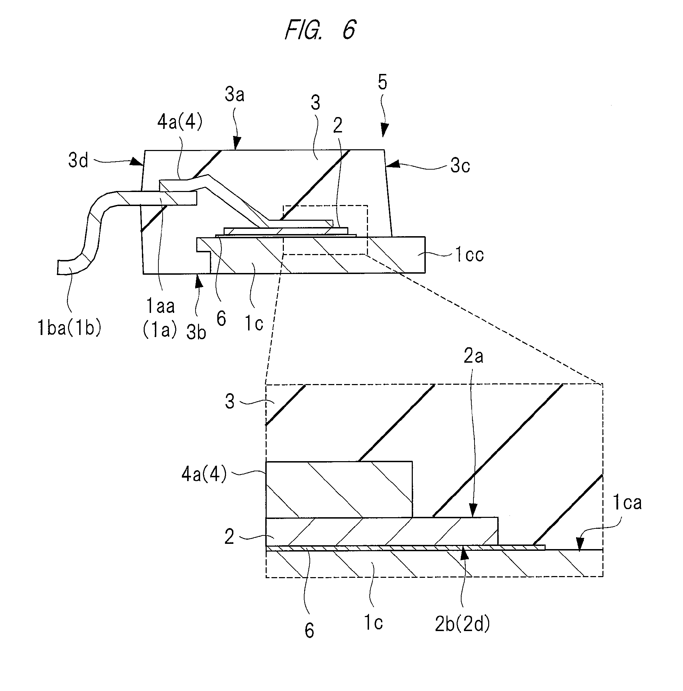

FIG. 1 is a plan view illustrating an example of a structure of a semiconductor device of an embodiment of the present invention, FIG. 2 is an arrow view seen from a direction A illustrated in FIG. 1, FIG. 3 is a rear view illustrating an example of a structure of a rear surface side of the semiconductor device illustrated in FIG. 1, and FIG. 4 is a transparent plan view transparently illustrating a structure of an inside of the semiconductor device illustrated in FIG. 1. In addition, FIG. 5 is a cross-sectional view illustrating an example of a structure cut out along the line A-A of FIG. 4, and FIG. 6 is a cross-sectional view and a partial enlarged cross-sectional view illustrating an example of a structure cut out along the line B-B of FIG. 4.

### <Semiconductor Device>

The semiconductor device of the present embodiment illustrated in FIGS. 1 to 6 is a semiconductor package which includes a sealing body 3 that seals a semiconductor chip (also referred to as a pellet) 2 and is made of an insulating resin, and further includes a plurality of leads 1 disposed inside and outside the sealing body 3. Each of the plurality of leads 1 includes an inner lead portion 1a covered with the sealing body 3, and an outer lead portion 1b exposed (protruding) from the sealing body 3 to the outside. Each of the plurality of outer lead portions 1b is an external connection terminal (external terminal) of the semiconductor device.

As illustrated in FIGS. 1 and 2, in the semiconductor device of the present embodiment, the plurality of outer lead portions 1b protrude from one side surface (second side surface 3d) among the plurality of side surfaces of the sealing body 3. Furthermore, as illustrated in FIGS. 3 and 5, a bottom surface (second surface) 1cb of a plate-shaped chip mounting portion (also referred to as an island, a die pad, a header, or a tab) 1c supporting a semiconductor chip 2 on a top surface (a chip mounting surface, a first surface) 1ca is exposed from a bottom surface (fourth surface) 3b of the sealing body 3. That is, the semiconductor device of the present embodiment is a surface mount type semiconductor device.

In addition, as illustrated in FIGS. 1 and 2, a protruding portion (the other part) 1cc of the chip mounting portion 1c protrudes from the first side surface 3c disposed on an opposite side of the second side surface 3d, from which the plurality of outer lead portions 1b protrude, among the side surfaces of the sealing body 3.

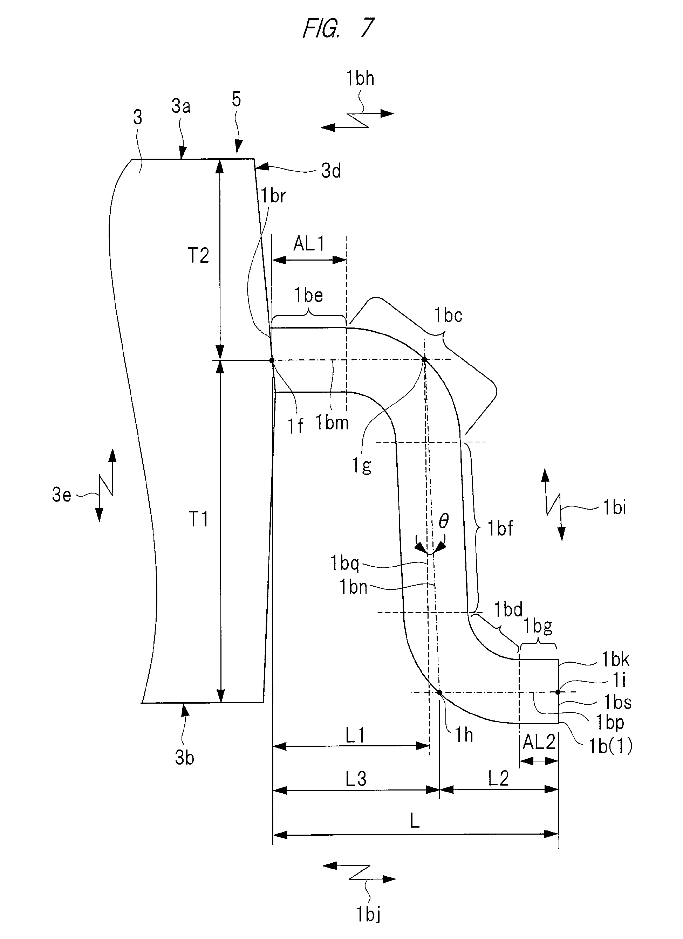

Each of the outer lead portions 1b of the plurality of leads 1 has a shape in which flexures (bendings) are formed at two positions. That is, each of the plurality of outer lead portions 1b has two bent portions (a first bent portion 1bc and a second bent portion 1bd illustrated in FIG. 7 to be described below).

In the present embodiment, as an example of a semiconductor device (power device) having the above-described structure, a power transistor 5 will be adopted and described. The semiconductor chip 2, in which a field effect transistor having a drain (D) electrode, a source (S) electrode, and a gate (G) electrode is formed, is incorporated in the power transistor 5.

A detailed structure of the power transistor 5 will be described below. The power transistor 5 includes the chip mounting portion 1c having the top surface (the first surface, the chip mounting surface) 1ca and the bottom surface (the second surface) 1cb on the opposite side of the top surface 1ca as illustrated in FIG. 5, and the semiconductor chip 2 mounted on the top surface 1ca of the chip mounting portion 1c through a die bond material 6 as illustrated in FIG. 6. The semiconductor chip 2 has a principal surface 2a as illustrated in FIG. 4, a plurality of first electrode pads (bonding electrodes, bonding pads) 2c formed in the principal surface 2a, and a rear surface 2b on an opposite side of the principal surface 2a as illustrated in FIG. 6. The semiconductor chip 2 is mounted on the chip mounting portion 1c such that the rear surface 2b faces the top surface 1ca of the chip mounting portion 1c. The rear surface 2b of the semiconductor chip 2 is a second electrode pad (a bonding electrode, a bonding pad) 2d and is the drain (D) electrode.

Furthermore, as illustrated in FIG. 4, the plurality of first electrode pads 2c of the principal surface 2a of the semiconductor chip 2 and the inner lead portions 1a of the plurality of leads 1 (see FIG. 1) are electrically connected through a plurality of wires (conductive members) 4.

The plurality of first electrode pads 2c of the semiconductor chip 2 include a first pad (source electrode) 2ca, and a second pad (gate electrode) 2cb smaller in size than the first pad 2ca when seen in a plan view.

In addition, the sealing body 3 illustrated in FIG. 6 has a top surface (a third surface) 3a that is disposed on the principal surface 2a side of the semiconductor chip 2 and forms a substantially rectangular shape when seen in a plan view as illustrated in FIG. 1, a bottom surface (a fourth surface) 3b that is disposed on an opposite side of the top surface 3a as illustrated in FIG. 3, and a first side surface 3c and a second side surface 3d that are disposed between the top surface 3a and the bottom surface 3b in a thickness direction of the semiconductor chip 2 as illustrated in FIG. 2. Furthermore, as illustrated in FIG. 3, the sealing body 3 seals a part of the chip mounting portion 1c (the top surface 1ca side illustrated in FIG. 5), and the semiconductor chip 2 and the plurality of wires 4 illustrated in FIG. 4 such that the bottom surface 1cb of the chip mounting portion 1c is exposed to the bottom surface 3b of the sealing body 3.

Since the semiconductor device of the present embodiment is the power transistor 5, as illustrated in FIGS. 1 and 4, the plurality of leads 1 (the outer lead portions 1b) protruding from the second side surface 3d of the sealing body 3 are a source lead (S) 1ba and a gate lead (G) 1bb. In addition, the rear surface 2b of the semiconductor chip 2 is the drain (D) electrode as described above. Therefore, the bottom surface 1cb of the chip mounting portion 1c exposed to the bottom surface 3b of the sealing body 3 as illustrated in FIG. 3 is the drain (D) electrode.

Note that each of the plurality of outer lead portions 1b is integrally formed with the inner lead portion 1a as illustrated in FIG. 4. That is, the source lead 1ba of the outer lead portion 1b is integrally connected to the source lead 1aa of the inner lead portion 1a. In addition, the gate lead 1bb of the outer lead portion 1b is integrally connected to the gate lead 1ab of the inner lead portion 1a.

The source lead 1aa of the inner lead portion 1a is widened connecting portions 1aaa and 1aab whose front ends connect the plurality of inner lead portions 1a. The wires 4 are connected to the wide connecting portions 1aaa and 1aab.

A wire (a first wire, a conductive member) 4a having a large diameter is electrically connected to the connecting portion 1aaa or the connecting portion 1aab of the source lead 1aa. Furthermore, the wire 4a is electrically connected to the source electrode (the first pad, the bonding electrode) 2ca of the first electrode pad 2c of the semiconductor chip 2.

That is, since a large current is applied to the source lead 1aa among the plurality of leads 1, the plurality of source leads 1aa and the source electrode 2ca of the semiconductor chip 2 are electrically connected through the wires 4a having a large diameter.

On the other hand, a wire (a second wire, a conductive member) 4b having a smaller diameter than the wire 4a is electrically connected to a wire connecting portion 1aba of the gate lead 1ab of the inner lead portion 1a. Furthermore, the wire 4b is electrically connected to the gate electrode (the second pad, the bonding electrode) 2cb of the first electrode pad 2c of the semiconductor chip 2.

That is, since a small current is applied to the gate lead 1ab among the plurality of leads 1, the gate lead 1ab and the gate electrode 2cb of the semiconductor chip 2 are electrically connected through the wire 4b.

In addition, as illustrated in FIGS. 4 and 5, a hanging lead 1e connected to the chip mounting portion 1c protrudes in the second side surface 3d of the sealing body 3.

The plurality of leads 1 including the chip mounting portion 1c or the hanging lead 1e connected to the chip mounting portion 1c, the inner lead portion 1a, and the outer lead portion 1b are made of, for example, a copper (Cu) alloy containing Cu as a main component. In addition, the die bond material 6 is, for example, a solder. It is preferable that the solder is, for example, a lead-free solder using tin (Sn). Furthermore, the wire 4 including the wire 4a and the wire 4b is made of, for example, aluminum (Al) . At this time, the diameter of the wire 4a is, for example, about 300 to 500 µm, and the diameter of the wire 4b is, for example, about 125 µm. In addition, the sealing body 3 is made of, for example, a thermosetting epoxy resin. However, the dimension or the material of each member described above is not limited to those described above.

Next, the shape of the outer lead portion 1b of the power transistor 5 of the present embodiment will be described.

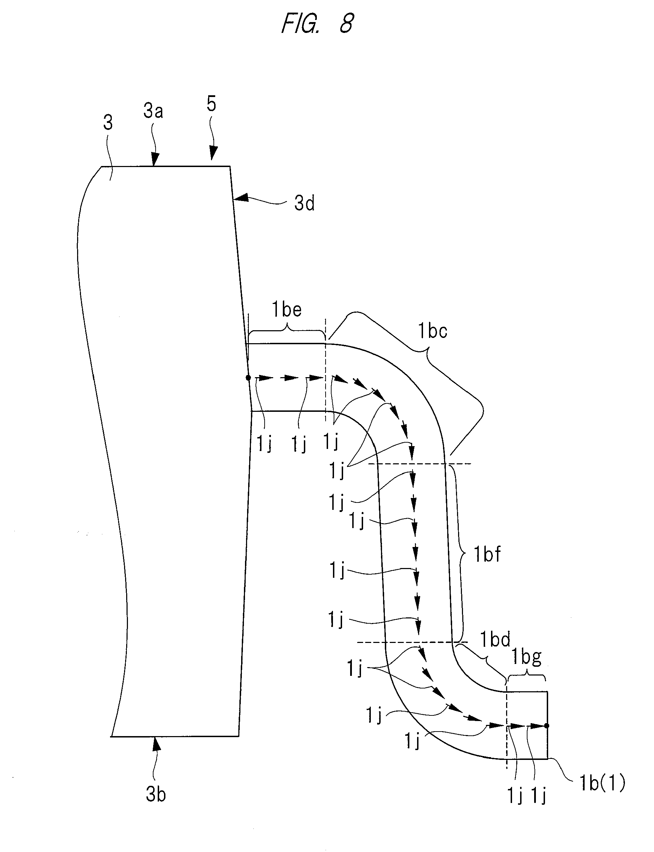

FIG. 7 is a schematic diagram illustrating a definition of the lead shape of the semiconductor device of the embodiment, and FIG. 8 is a schematic diagram illustrating another definition of the lead shape of the semiconductor device of the embodiment.

As illustrated in FIG. 7, each of the plurality of outer lead portions 1b in the power transistor 5 includes a first portion 1be protruding from the second side surface 3d of the sealing body 3 in a first direction 1bh, a second portion 1bf extending in a second direction 1bi intersecting with the first direction 1bh, and a third portion 1bg extending in a third direction 1bj intersecting with the second direction 1bi. The first portion 1be, the second portion 1bf, and the third portion 1bg are linearly extending portions.

The first portion 1be and the second portion 1bf are connected through the first bent portion 1bc, and the second portion 1bf and the third portion 1bg are connected through the second bent portion 1bd.

Therefore, each of the outer lead portions 1b includes five portions, that is, the first portion 1be, the first bent portion 1bc, the second portion 1bf, the second bent portion 1bd, and the third portion 1bg.

In the power transistor 5 of the present embodiment, a length AL2 of the third portion 1bg linearly extending in the third direction 1bj is shorter than a length AL1of the first portion 1be linearly extending in the first direction 1bh (AL1 > AL2).

Here, the length AL1 of the first portion 1be is a length from the second side surface 3d of the sealing body 3 to the first bent portion 1bc, and the length AL2 of the third portion 1bg is a length from a front end 1bk of the outer lead portion 1b to the second bent portion 1bd.

Furthermore, the first bent portion 1bc is a portion that is bent from the first direction 1bh toward the second direction 1bi (toward a vertical direction of the semiconductor device), and the second bent portion 1bd is a portion that is bent from the second direction 1bi toward the third direction 1bj (toward a horizontal direction of the semiconductor device) .

In addition, the first direction 1bh and the third direction 1bj are parallel or substantially parallel to the top surface (the third surface) 3a of the sealing body 3.

Furthermore, a position protruding from the second side surface 3d of the sealing body 3 of the outer lead portion 1b in the power transistor 5 (a position of a first intersecting portion If to be described below) is a position closer to the top surface (the third surface) 3a of the sealing body 3 than the bottom surface (the fourth surface) 3b of the sealing body 3 in a thickness direction 3e of the sealing body 3.

That is, T2 < T1 where T1 is a distance from the position protruding from the second side surface 3d of the sealing body 3 of the outer lead portion 1b (the position of the first intersecting portion If to be described below) to the bottom surface 3b of the sealing body 3, and T2 is a distance from the position (the first intersecting portion If) protruding from the second side surface 3d of the sealing body 3 of the outer lead portion 1b to the top surface 3a of the sealing body 3.

Therefore, since the distance T1 is long, the length of the second portion 1bf of the outer lead portion 1b is also long. Thus, when a stress such as a thermal stress is applied at the time of mounting the power transistor 5 on a mounting substrate or the like, the thermal stress can be alleviated by the long second portion 1bf of the outer lead portion 1b and the mounting reliability can be improved.

In the power transistor 5 having the above-described structure, the length AL2 of the third portion 1bg of the outer lead portion 1b is formed to be shorter than the length AL1 of the first portion 1be of the outer lead portion 1b (ALl > AL2). Therefore, it is possible to reduce the mounting area of the power transistor 5. Furthermore, the third portion 1bg of the outer lead portion 1b is connected to a land of the mounting substrate. Therefore, when the length AL2 of the third portion 1bg is reduced, the area connected to the land of the mounting substrate may become small and the connection strength between the power transistor 5 and the mounting substrate may be reduced. However, for example, as illustrated in FIG. 5, the bottom surface 1cb of the chip mounting portion 1c is exposed from the bottom surface 3b of the sealing body 3, and the protruding portion (the other part) 1cc of the chip mounting portion 1c protrudes from the first side surface 3c disposed on an opposite side of the second side surface 3d from which the plurality of outer lead portions 1b protrude. As a result, the exposed surface (the bottom surface 1cb) and the protruding portion 1cc are tightly connected to the land of the mounting substrate through a conductive adhesive (for example, a solder or the like). Therefore, the connection strength between the power transistor 5 and the mounting substrate can be maintained, and the length AL2 of the third portion 1bg of the outer lead portion 1b can be shortened. In other words, since a large portion of the power transistor 5 is connected to the land of the mounting substrate, the reliability in the connection strength between the power transistor 5 and the mounting substrate can be maintained even when the length AL2 of the third portion 1bg of the outer lead portion 1b is shortened in the second side surface 3d of the sealing body 3.

Here, as illustrated in FIG. 8, differences (definitions) between the first portion 1be, the second portion 1bf, and the third portion 1bg, which are the linear portions, and the first bent portion 1bc and the second bent portion 1bd, which are the bent portions, in the outer lead portion 1b will be described below. In the linear portions, a plurality of vectors 1j in the center value (line) of the outer lead portion 1b face the same direction. In contrast, in the curved portions, the plurality of vectors 1j in the center value (line) of the outer lead portion 1b face different directions.

In other words, the linear portion of the outer lead portion 1b is a portion that is not intentionally bent. On the other hand, the bent portion of the outer lead portion 1b is a portion that is intentionally bent.

Next, characteristics of the power transistor 5 of the present embodiment will be described with alternative representation. That is, as illustrated in FIG. 7, the first portion 1be of each of the outer lead portions 1b has a first front end surface (base end side) 1br continuous to the second side surface 3d of the sealing body 3. The second portion 1bf of the outer lead portion 1b is disposed between the first portion 1be and the third portion 1bg of the outer lead portion 1b. Furthermore, the third portion 1bg of the outer lead portion 1b has a second front end surface (front end side) 1bs disposed on an opposite side of the first front end surface 1br.

L1 is assumed to be a length from a first intersecting portion If, which is an intersecting portion between a first virtual line 1bm and the first front end surface 1br of the first portion 1be, to a second intersecting portion 1g, which is an intersecting portion between an extension line of the first virtual line 1bm of the first portion 1be and an extension line of a second virtual line 1bn of the second portion 1bf. Furthermore, L2 is assumed to be a length from a third intersecting portion 1h, which is an intersecting portion between an extension line of a third virtual line 1bp of the third portion 1bg and an extension line of the second virtual line 1bn of the second portion 1bf, to a fourth intersecting portion 1i, which is an intersecting portion between the third virtual line 1bp of the third portion 1bg and the second front end surface 1bs. At this time, the length is L1 > L2.

Here, the first virtual line 1bm is a line that passes through the center in the thickness direction of the first portion 1be and extends in parallel to the surface of the first portion 1be. The second virtual line 1bn is a line that passes through the center in the thickness direction of the second portion 1bf and extends in parallel to the surface of the second portion 1bf. The third virtual line 1bp is a line that passes through the center in the thickness direction of the third portion 1bg and extends in parallel to the surface of the third portion 1bg.

In addition, each of the first virtual line 1bm and the third virtual line 1bp is parallel or substantially parallel to the top surface 3a of the sealing body 3.

Furthermore, an angle θ between the fourth virtual line 1bq extending in parallel to the thickness direction 3e of the sealing body 3 and the second virtual line 1bn is 6° or less. In other words, the angle θ is an angle between a straight line parallel to the second direction 1bi and a straight line parallel to the thickness direction 3e of the sealing body 3. That is, the angle θ is a bending angle of the first bent portion 1bc at the time of forming the outer lead portion 1b (bending forming of lead) and is a bending angle of the outer lead portion 1b at the time of punching the outer lead portion 1b with a punch.

The angle θ is 0 < θ ≤ 6°.

In the power transistor 5 having the above-described structure, a distance L2 between the third intersecting portion 1h and the fourth intersecting portion 1i of the outer lead portion 1b is formed to be shorter than a distance L1 between the first intersecting portion If and the second intersecting portion 1g of the outer lead portion 1b (L1 > L2). Therefore, it is possible to reduce the mounting area of the power transistor 5.

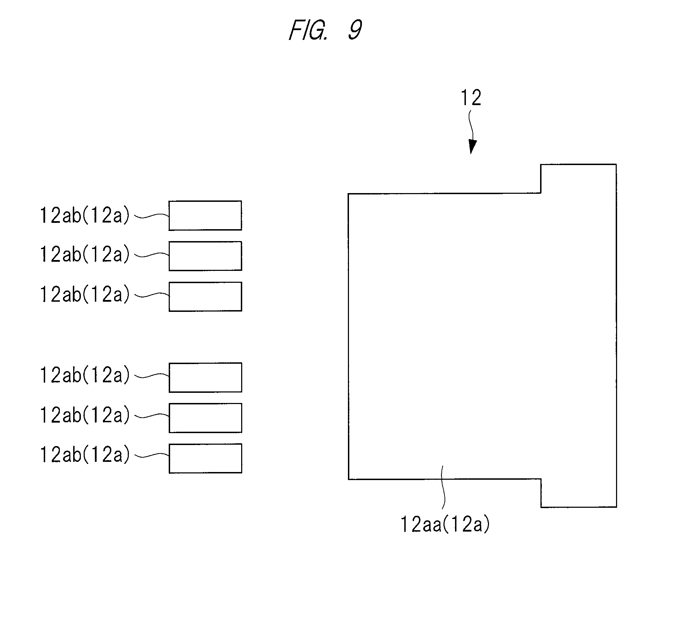

Next, a relationship between the outer lead portion 1b of the power transistor 5 of the present embodiment and the land 12a of the mounting substrate 12 will be described with reference to FIGS. 9 to 11.

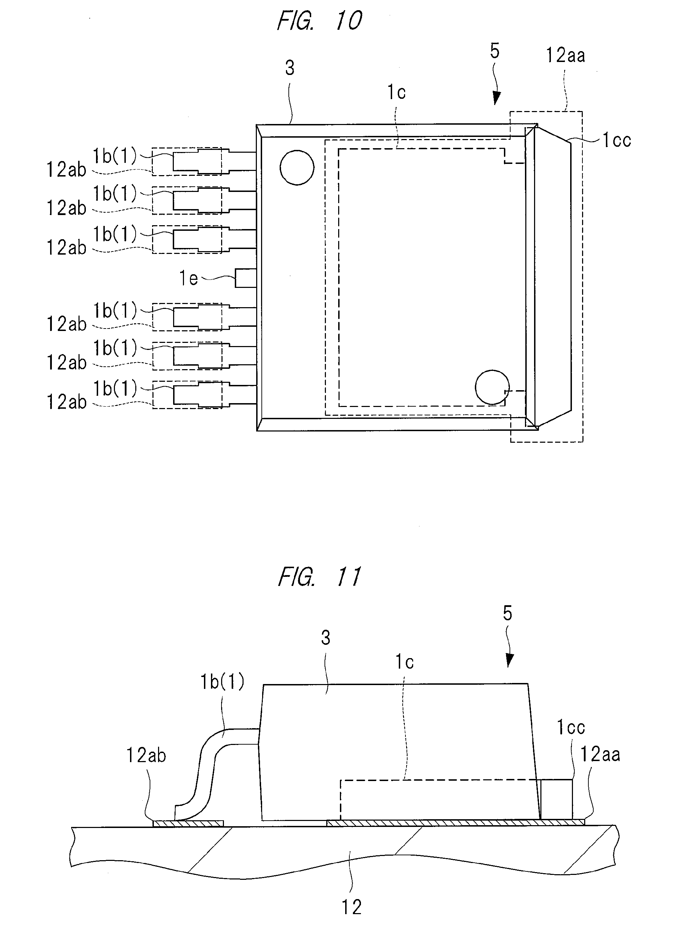

FIG. 9 is a plan view illustrating an example of a land pattern in the mounting substrate on which the semiconductor device of the present embodiment is mounted, FIG. 10 is a plan view illustrating an example of a structure in which the semiconductor device of the embodiment is mounted on the land pattern illustrated in FIG. 9, and FIG. 11 is a side view illustrating an example of a mounting structure of FIG. 10.

FIGS. 10 and 11 illustrate the structure in which the power transistor 5 of the present embodiment is mounted in an island land 12aa and lead lands 12ab of the land (electrode, terminal) 12a of the mounting substrate 12 illustrated in FIG. 9. The third portion 1bg of each outer lead portion 1b, which is illustrated in FIG. 7, is disposed on each lead land 12ab, and the chip mounting portion 1c is disposed on the island land 12aa.

In the power transistor 5 of the present embodiment, since the length of the third portion 1bg, which is a bonding portion to the land 12a in the outer lead portion 1b, is short, the length of the lead land 12ab, which is connected thereto, in an extending direction can be shortened as illustrated in FIG. 9. By shortening the length of each lead land 12ab, as illustrated in FIGS. 10 and 11, it is possible to reduce the mounting area of the power transistor 5.

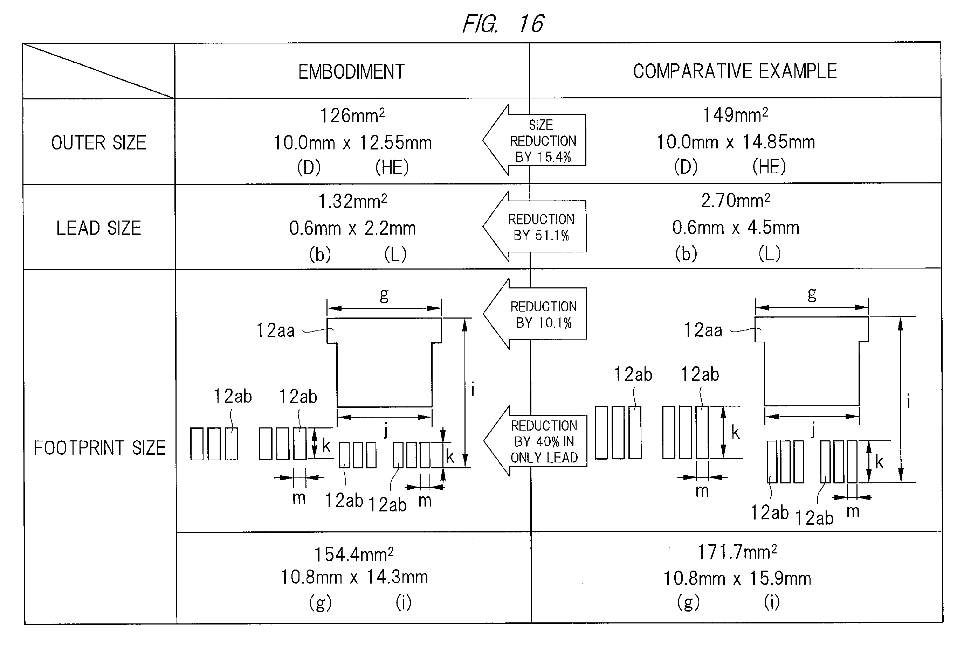

As illustrated in FIG. 16 to be described below, it is possible to reduce the footprint in the mounting substrate 12.

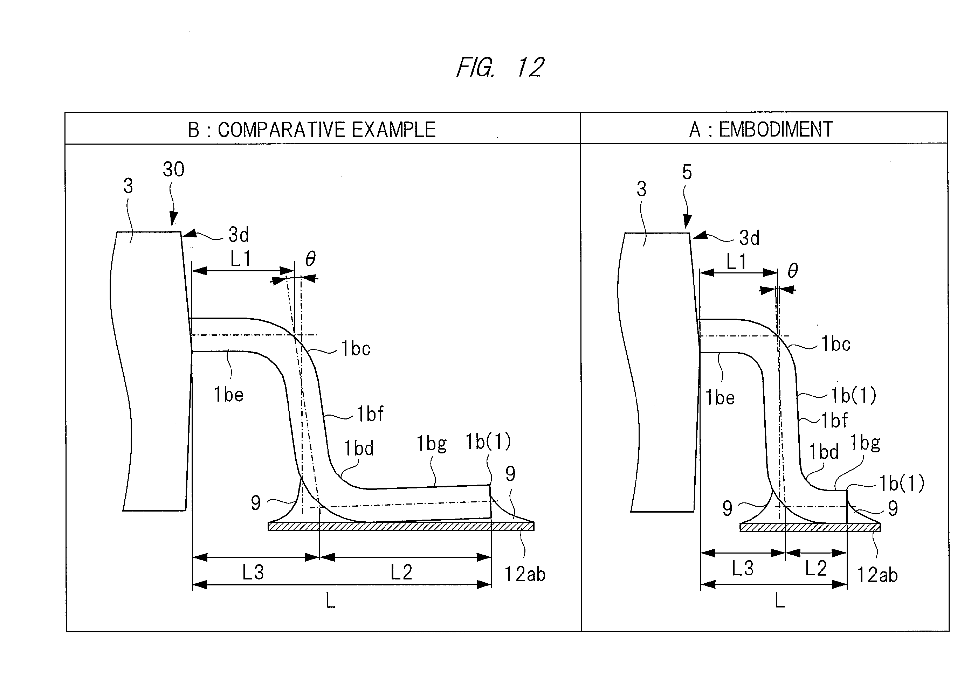

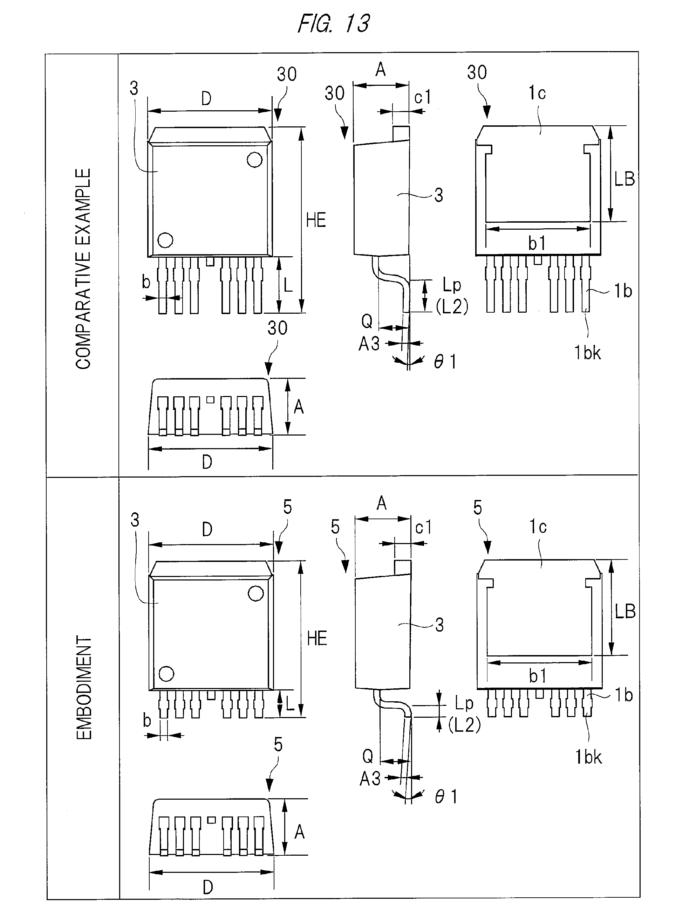

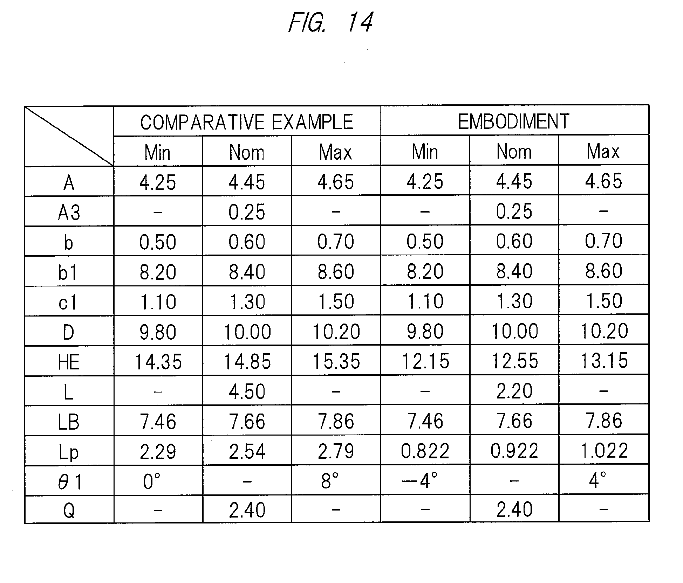

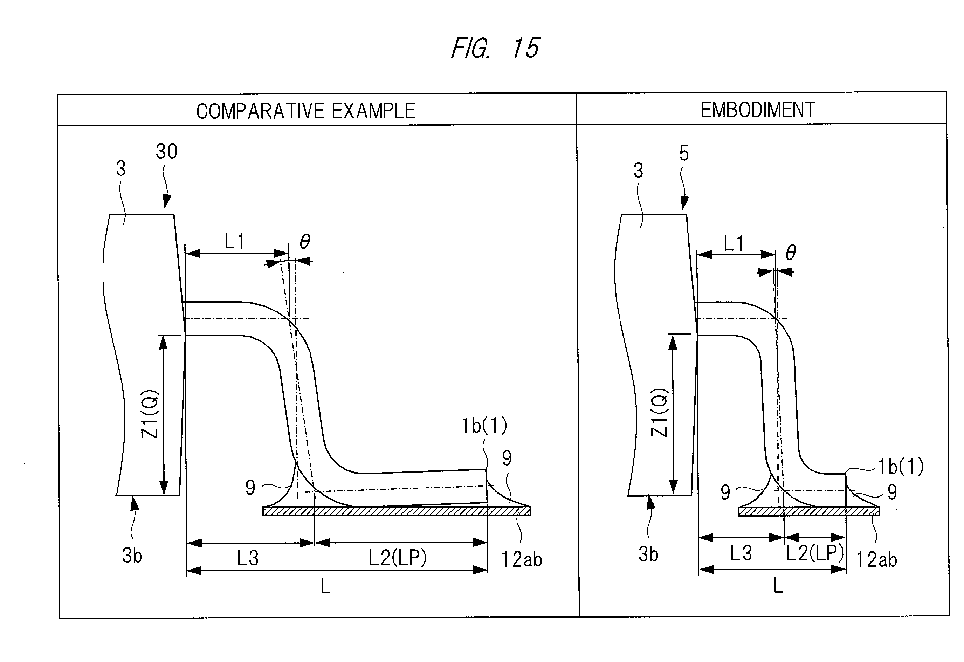

Next, the comparison of an outer shape specification between the power transistor 5 of the present embodiment and a standard product package 30 such as Joint Electron Device Engineering Council (JEDEC) standards will be described. FIG. 12 is a comparison diagram illustrating a lead shape of the semiconductor device of the embodiment and a lead shape of the semiconductor device of the comparative example (standard product package 30), and FIG. 13 is an external comparison diagram illustrating an example of each dimension of the semiconductor device of the embodiment and the semiconductor device of the comparative example. Furthermore, FIG. 14 is a data diagram illustrating an example of each dimension illustrated in FIG. 13, FIG. 15 is a comparison diagram of an aspect ratio of the lead in the semiconductor device of the embodiment and the semiconductor device of the comparative example, and FIG. 16 is a comparison diagram illustrating the effects by the comparison between the semiconductor device of the embodiment and the semiconductor device of the comparative example.

Here, as an example of the standard product package 30, TO-263 of the JEDEC will be described as the comparative example. FIG. 12 illustrates a state in which the outer lead portion 1b is bonded to the lead land 12ab of the mounting substrate 12 illustrated in FIG. 11 by a solder 9 in each of the power transistor 5 of the present embodiment and the standard product package 30 of the comparative example.

First, in the power transistor 5 of the present embodiment and the standard product package 30 of the comparative example, the shape of each outer lead portion 1b will be described.

As illustrated in FIG. 12, in the standard product package 30 of the comparative example (B), the lead length L of the outer lead portion 1b is sufficiently secured. Therefore, a length L1 from the second side surface 3d of the sealing body 3 of the outer lead portion 1b to the first bent portion 1bc, a length L2 of the mounting portion including the third portion 1bg, and a forming angle (bending angle: θ + 90°) of the outer lead portion 1b have a certain degree of freedom.

When reviewing the standard product package 30, it is considered that L1 < L2 and there is a relationship of θ ≥ 6°.

On the contrary, in the power transistor 5 of the present embodiment (A), a lead length L including the third portion 1bg of the outer lead portion 1b is shortened (a distance L2 between the third intersecting portion 1h and the fourth intersecting portion 1i of the outer lead portion 1b illustrated in FIG. 7 is shorter than a distance L1 between the first intersecting portion If and the second intersecting portion 1g of the outer lead portion 1b (L1 > L2)).

That is, in order to sufficiently secure the length (distance) L2, the length (distance) L1 is minimized. Furthermore, in order to sufficiently secure the length (distance) L2, the bending angle (θ + 90°) in the first bent portion 1bc is reduced to the possible extent.

θ in the bending angle of the first bent portion 1bc of the outer lead portion 1b is set to 6° or less (0 < θ ≤ 6°), while forming the portion of the length L1 to be short in a possible range. The portion (the second portion 1bf) disposed in the thickness direction 3e of FIG. 7 of the sealing body 3 of the outer lead portion 1b can be vertically brought close. As a result, the portion of the length L2 is lengthened in a possible range.

On the other hand, when θ in the bending angle of the first bent portion 1bc of the outer lead portion 1b is set to 0° or less (in other words, bending to the sealing body side), it is possible to reduce the lead length L of the outer lead portion 1b, but the bending angle of the first bent portion 1bc becomes an acute angle. As a result, the durability of the outer lead portion 1b is significantly reduced.

That is, the power transistor 5 of the present embodiment has a relationship of L1 > L2 and 0 < θ ≤ 6°. Thus, it is possible to sufficiently secure the length L2 and it is possible to sufficiently satisfy the durability of the lead.

Therefore, the power transistor 5 of the present embodiment can realize a stable forming (bending forming) of the outer lead portion 1b, secure the mounting strength with respect to the mounting substrate, and reduce the mounting area of the power transistor 5.

Next, the outer sizes of various portions in the power transistor 5 of the present embodiment and in the standard product package 30 of the comparative example will be described with reference to FIGS. 13 and 14.

As shown in dimension data of FIG. 14, in the power transistor 5 (embodiment) and the standard product package 30 (comparative example), values are mainly different in the portions related to the lead length L. That is, since the thickness of the sealing body 3 or the size of the sealing body 3 when seen in a plan view, or the size of the chip mounting portion 1c when seen in a plan view, and the like are equal to one another, only the dimensions of the portions related to the lead length L are different.

That is, the distance L2 (Lp) is 0.922 mm in the power transistor 5 and is 2.54 mm in the standard product package 30. The lead length L is 2.20 mm in the power transistor 5 and is 4.50 mm in the standard product package 30.

In addition, a distance HE from the end of the chip mounting portion 1c to the front end 1bk of the outer lead portion 1b is 12.55 mm in the power transistor 5 and is 14.85 mm in the standard product package 30. A difference of the lead length L is a difference of the distance HE as it is.

The dimensions of the other portions except for the angle θ1 are equal in the power transistor 5 and the standard product package 30.

Next, the condition of the outer lead portion 1b of the power transistor 5 of the present embodiment in the height direction will be described.

The condition of the outer lead portion 1b of the power transistor 5 in the height direction can be represented by an aspect ratio of the outer lead portion 1b. The aspect ratio of the shape of the outer lead portion 1b of each of the power transistor 5 and the standard product package 30 will be described with reference to FIGS. 14 and 15.

As illustrated in FIG. 15, the aspect ratio of the outer lead portion 1b of the standard product package 30 is the length L3 = L - Lp (L2) = 4.5 - 2.54 = 1.96, and the height Z1 (Q) from the bottom surface 3b of the sealing body 3 to the outer lead portion 1b is 2.4.

Therefore, the aspect ratio is L3/Z1 = 1.96/2.4 = 0.817. Thus, the aspect ratio of the outer lead portion 1b of the standard product package 30 is L3/Z1 ≤ 0.75.

On the other hand, the aspect ratio of the outer lead portion 1b of the power transistor 5 of the present embodiment is the length L3 = L - Lp (L2) = 2.2 - 0.922 = 1.278, and the height Z1(Q) from the bottom surface 3b of the sealing body 3 to the outer lead portion 1b is 2.4.

Therefore, the aspect ratio is L3/Z1 = 1.278/2.4 = 0.5325. Thus, the aspect ratio of the outer lead portion 1b of the power transistor 5 is L3/Z1 ≤ 0.55.

That is, in the power transistor 5, the aspect ratio (L3/Z1) of the outer lead portion 1b is L3/Z1 ≤ 0.55.

The effects of the power transistor 5 of the present embodiment with respect to the standard product package 30 of the comparative example will be described in terms of the outer size, the lead size, and the footprint size with reference to FIG. 16.

First, when the outer size is calculated using the appearance diagram of FIG. 13 and the dimension data of FIG. 14, the outer size of the standard product package 30 is length D x length HE = 10.0 mm x 14.85 mm = 149 mm². On the other hand, the outer size of the power transistor 5 is length D x length HE = 10.0 mm x 12.55 mm = 126 mm². Therefore, since the area of 149 mm² is reduced to the area of 126 mm², the outer size of the power transistor 5 can be reduced by 15.4%.

In addition, the lead size of the standard product package 30 is length b x length L = 0.6 mm x 2.2 mm = 1.32 mm². On the other hand, the lead size of the power transistor 5 is length b x length L = 0.6 mm x 4.5 mm = 2.70 mm². Therefore, since the area of 2.70 mm² is reduced to the area of 1.32 mm², the lead size of the power transistor 5 can be reduced by 51.1%.

In addition, regarding the footprint size of the mounting substrate 12 illustrated in FIG. 9, the area of the standard product package 30 of the comparative example with respect to the island land 12aa is length g x length i = 10.8 mm x 15.9 mm = 171.7 mm². On the other hand, the area of the power transistor 5 of the present embodiment is length b x length I = 10.8 mm x 14.3 mm = 154.4 mm². Therefore, since the area of 171.7 mm² is reduced to the area of 154.4 mm², the footprint size of the island land 12aa in the power transistor 5 can be reduced by 10.1%.

In addition, regarding the lead land 12ab of the footprint size, the area of the standard product package 30 of the comparative example is length k x length m = 4 mm x 0.9 mm = 3.6 mm². On the other hand, the area of the power transistor 5 of the embodiment is length k x length m = 2.4 mm x 0.9 mm = 2.16 mm². Therefore, since the area of 3.6 mm² is reduced to the area of 2.16 mm², the footprint size of the lead land 12ab in the power transistor 5 can be reduced by 40%.

Next, a mounting strength test of the power transistor 5 of the present embodiment will be described with alternative representation.

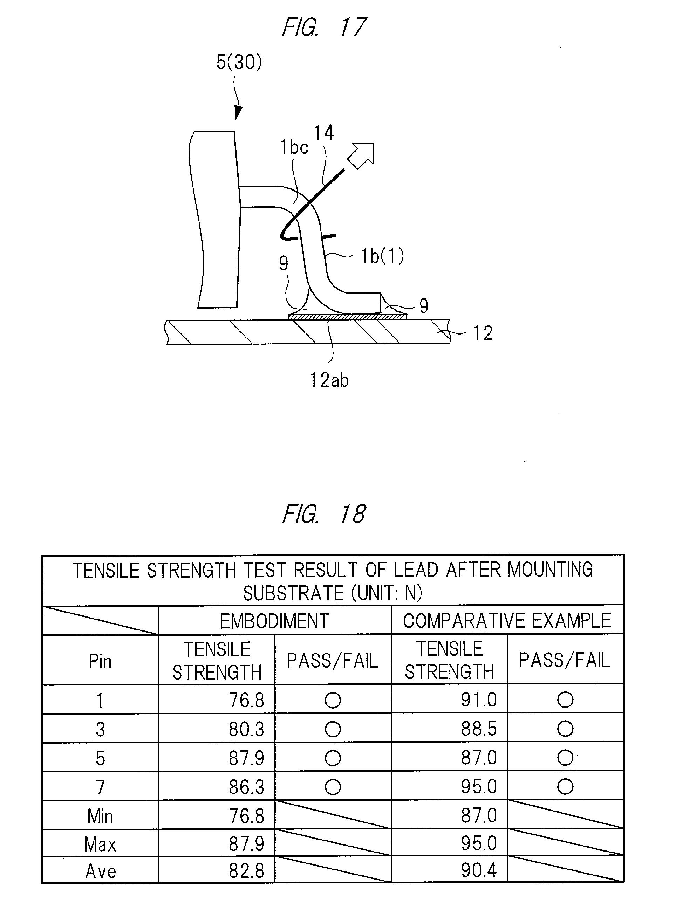

FIG. 17 is a test condition diagram illustrating an example of a method of testing a mounting strength in the semiconductor device of the embodiment, and FIG. 18 is a data diagram illustrating test results of the mounting strength in the semiconductor device of the embodiment and the semiconductor device of the comparative example.

As illustrated in FIG. 17, in the mounting strength test of the present embodiment, the outer lead portion 1b is bonded to the land 12ab of the mounting substrate 12 or the like by the solder 9, and in this state, the wire member 14 is hooked on the outer lead portion 1b and is pulled upward by 45°. A tensile strength at this time is measured. In the present embodiment, the tensile strength is measured in each of the power transistor 5 of the embodiment and the standard product package 30 of the comparative example.

According to the test result illustrated in FIG. 18, the mounting strength measurement result of the standard product package 30 is 90.4N in average. Here, since the effect of the size reduction in only the lead land 12ab illustrated in FIG. 16 is the 40% reduction, the mounting strength is regarded as pass if obtaining a measured value in which the mounting strength of the power transistor 5 with respect to the mounting strength of the standard product package 30 is reduced by 20% or more.

Specifically, since the average value of the mounting strength of the standard product package 30 is 90.4N, 90.4 x 0.8 = 72.32N. Therefore, when the measured value of the mounting strength of the power transistor 5 is greater than 72.32N, the mounting strength is regarded as pass. With reference to the measured values in FIG. 18, in the power transistor 5, the measured values of all Pins (1, 3, 5, and 7 pins) of the measurement target are greater than 72.32N, and therefore, the mounting strength using the solder bonding of the power transistor 5 of the present embodiment can be regarded as pass.

### <Method of Manufacturing Semiconductor Device>

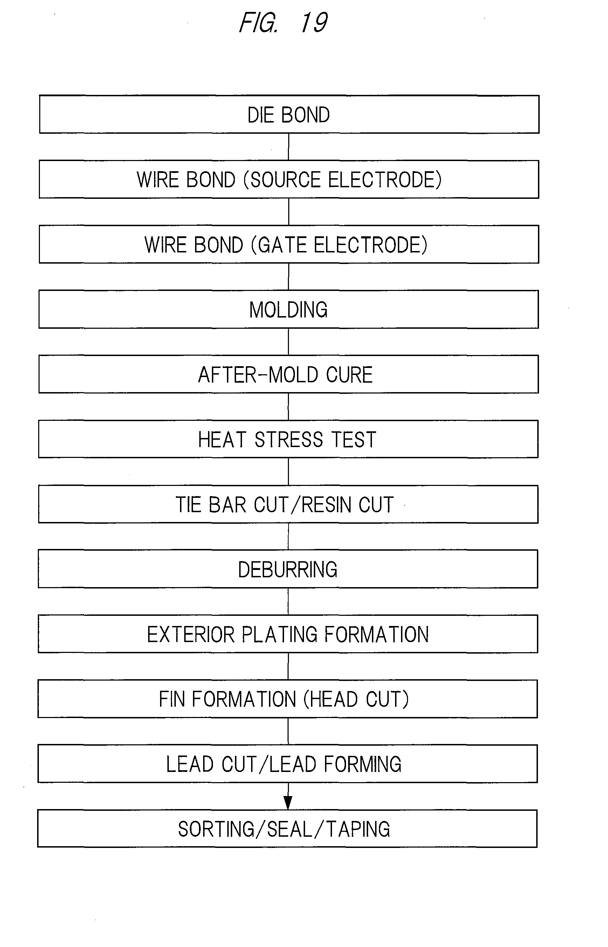

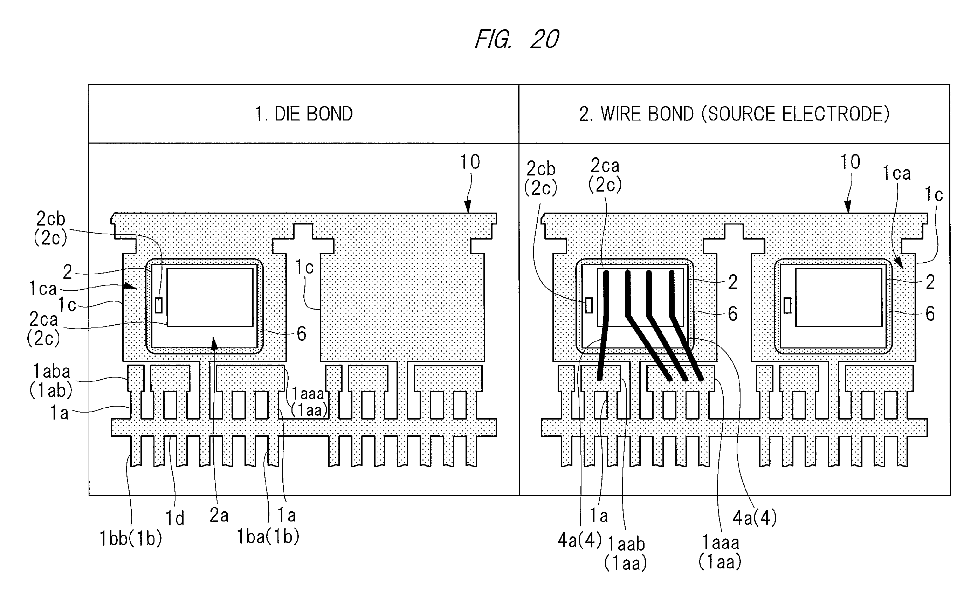

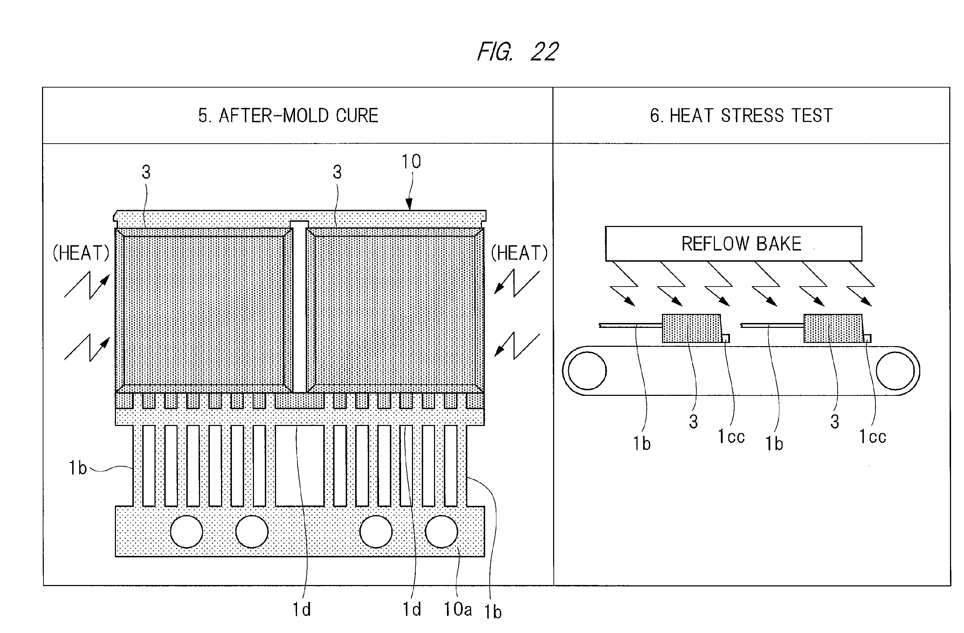

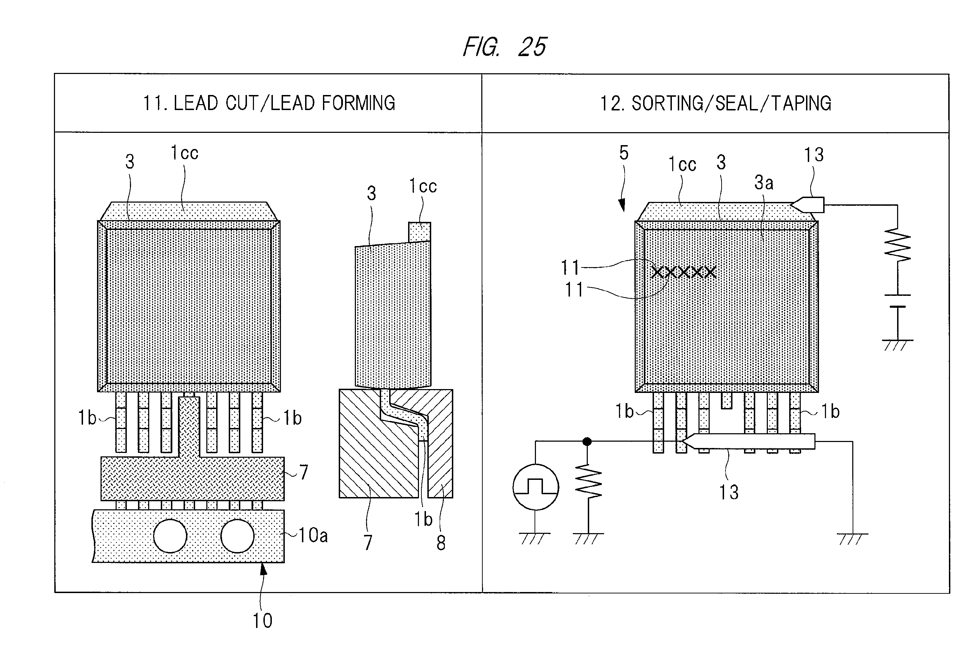

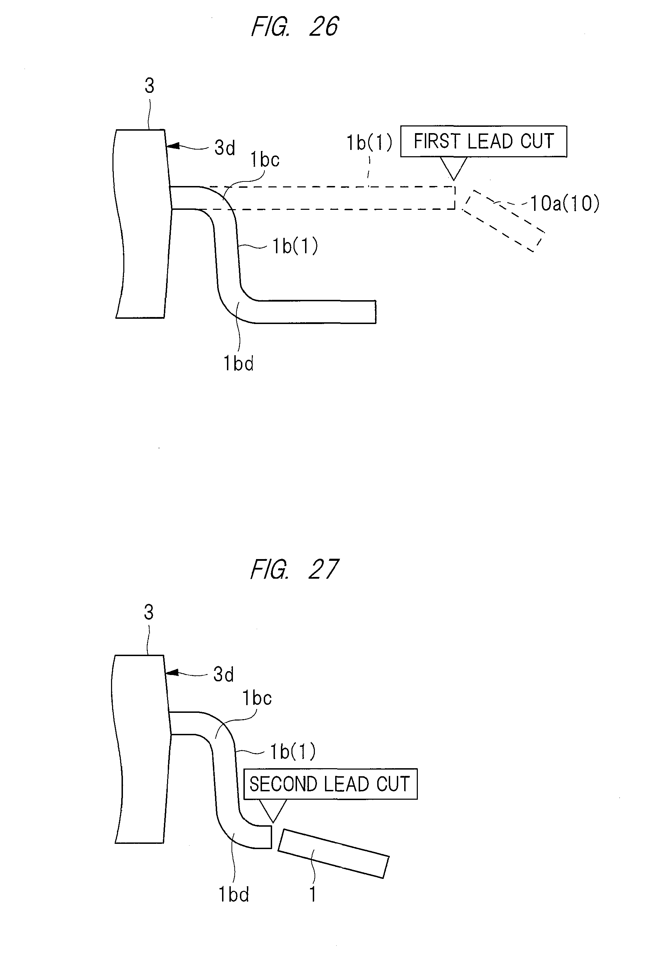

FIG. 19 is a flow diagram illustrating a procedure of assembling the semiconductor device of the embodiment, and FIGS. 20 to 25 are plan views illustrating an example of a main process in the assembling of the semiconductor device of the embodiment. FIG. 22 is also a side view illustrating the same. FIG. 25 is also a cross-sectional view illustrating the same. Further, FIG. 26 is a partial cross-sectional view illustrating a structure after a first lead cut in a lead cut of the assembling of the semiconductor device of the embodiment, and FIG. 27 is a partial cross-sectional view illustrating a structure after a second lead cut in the lead cut of the assembling of the semiconductor device of the embodiment.

A method of manufacturing the power transistor 5 will be described with reference to the flow illustrated in FIG. 19.

First, a lead frame 10 having a plurality of device regions as illustrated in FIG. 20 is prepared.

The lead frame 10 is a plate-shaped frame member made of, for example, a metal material (Cu alloy) containing copper (Cu) as a main component.

In the present embodiment, for convenience, two device regions will be representatively taken, and the assembling of the power transistor 5 thereafter will be described.

### 1. Die Bond

After the preparation of the lead frame is completed, a die bond illustrated in FIG. 19 is performed.

In the die bond process, as illustrated in FIG. 20, the semiconductor chip 2 is mounted on the top surface 1ca of the chip mounting portion 1c through the die bond material 6. That is, the semiconductor chip 2, in which the plurality of first electrode pads 2c are formed on the principal surface 2a, is mounted on the chip mounting portion 1c through the die bond material 6.

### 2. Wire Bond (Source Electrode)

After the die bond is completed, a wire bond of the source electrode illustrated in FIG. 19 is performed.

In the wire bond process, as illustrated in FIG. 20, the source electrode 2ca among the plurality of first electrode pads 2c of the semiconductor chip 2 and the connecting portions 1aaa and 1aab of the source lead 1aa among the plurality of inner lead portions 1a are electrically connected through the wires 4a.

### 3. Wire Bond (Gate Electrode)

After the wire bond of the source electrode is completed, a wire bond of the gate electrode illustrated in FIG. 19 is performed.

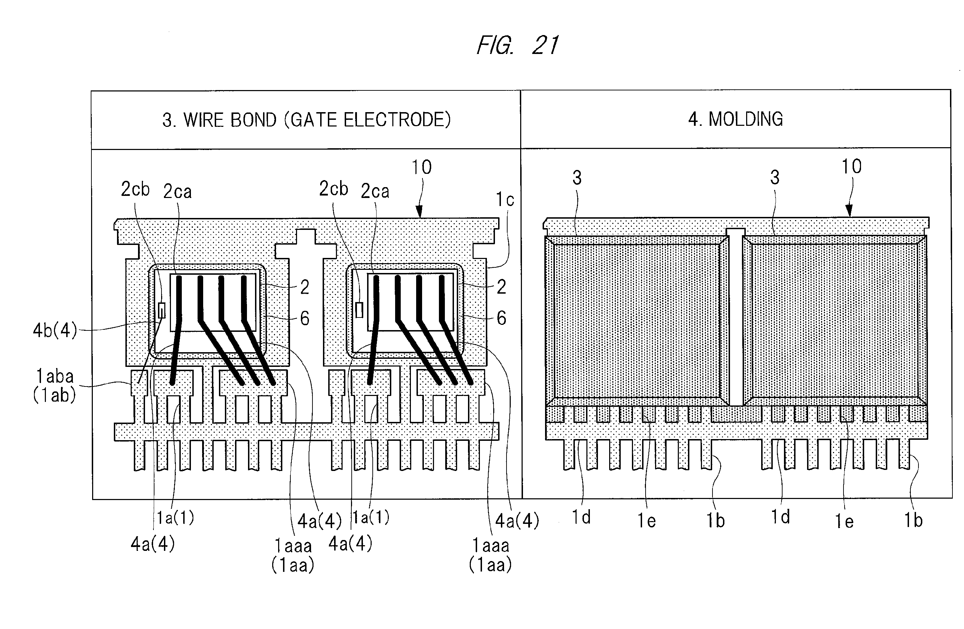

In the wire bondprocess, as illustrated in FIG. 21, the gate electrode 2cb among the plurality of first electrode pads 2c of the semiconductor chip 2 and the wire connecting portion 1aba of the gate lead 1ab among the plurality of inner lead portions 1a are electrically connected through the wires 4b. The wires 4a or the wires 4b are, for example, thin metal lines made of Al.

### 4. Molding

After the wire bond of the gate electrode is completed, a molding illustrated in FIG. 19 is performed.

In the molding process, the semiconductor chip 2, a part (top surface 1ca side) of the chip mounting portion 1c, the plurality of inner lead portions 1a, and the plurality of wires 4 illustrated in FIG. 4 are sealed using a sealing resin. At this time, first, the wire-bonded lead frame 10 is disposed within a cavity of a resin forming mold (not illustrated), and the lead frame 10 is clamped in the mold. Then, the sealing body 3 illustrated in FIG. 21 is formed by filling the cavity with the sealing resin. The sealing resin is, for example, a thermosetting epoxy resin.

At this time, as illustrated in FIG. 4, the protruding portion 1cc of the chip mounting portion 1c protrudes from the first side surface 3c of the sealing body 3. On the other hand, the plurality of outer lead portions 1b protrude from the second side surface 3d. Furthermore, as illustrated in FIG. 3, the sealing body 3 is formed such that the bottom surface 1cb of the chip mounting portion 1c is exposed from the bottom surface 3b.

### 5. After-Mold Cure

After the molding is completed, an after-mold cure illustrated in FIG. 19 is performed.

In the after-mold cure process, as illustrated in FIG. 22, the sealing body 3 is cured by applying heat to the formed sealing body 3.

Therefore, as illustrated in FIGS. 3 and 5, the protruding portion 1cc of the chip mounting portion 1c protrudes from the first side surface 3c of the sealing body 3, the plurality of outer lead portions 1b protrude from the second side surface 3d, and furthermore, the bottom surface 1cb of the chip mounting portion 1c is exposed from the bottom surface 3b.

### 6. Heat Stress Test

After the after-mold cure, a heat stress test (IR) illustrated in FIG. 19 is performed.

In the heat stress test process, as illustrated in FIG. 22, the stress test is performed by using a reflow bake to apply heat to the sealing body 3 after the mold is completed.

### 7. Tie Bar Cut/Resin Cut

After the heat stress test, a tie bar cut and a resin cut illustrated in FIG. 19 is performed.

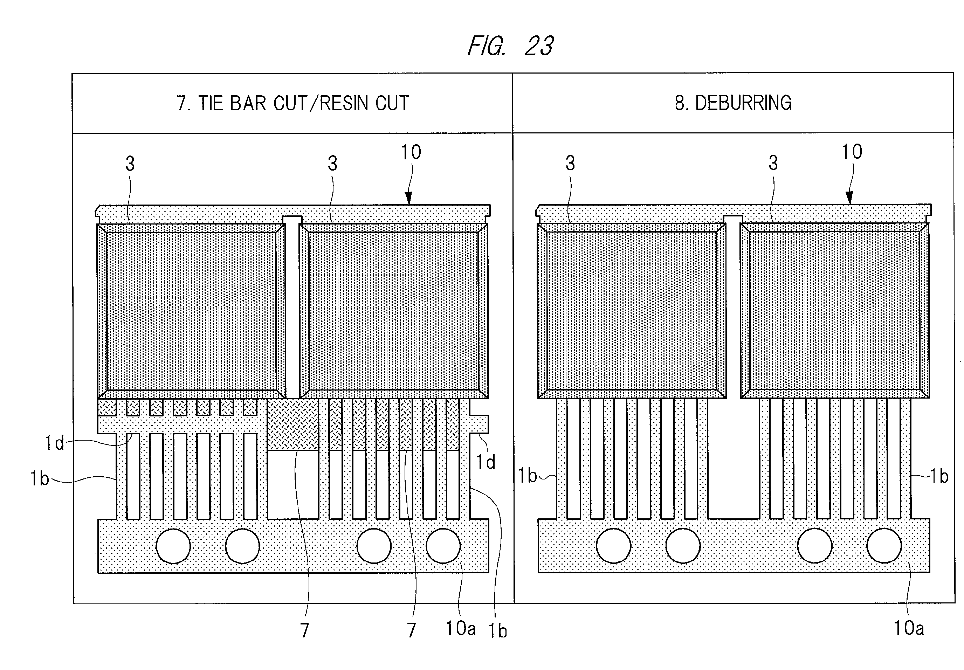

In the tie bar cut/resin cut process, as illustrated in FIG. 23, a tie bar 1d disposed between the adjacent outer lead portions 1b is cut by a punch 7. Therefore, the adjacent outer lead portions 1b are separated from each other, and the resin formed between the sealing body 3 and the tie bar 1d is cut off.

### 8. Deburring

After the die bar cut and the resin cut, a deburring illustrated in FIG. 19 is performed.

In the deburring process, as illustrated in FIG. 23, the resin or metal burr generated by the tie bar cut and resin cut is removed. The deburring is performed by laser irradiation or water jet, but the method is not limited thereto.

### 9. Exterior Plating Formation

After the deburring, an exterior plating formation illustrated in FIG. 19 is performed.

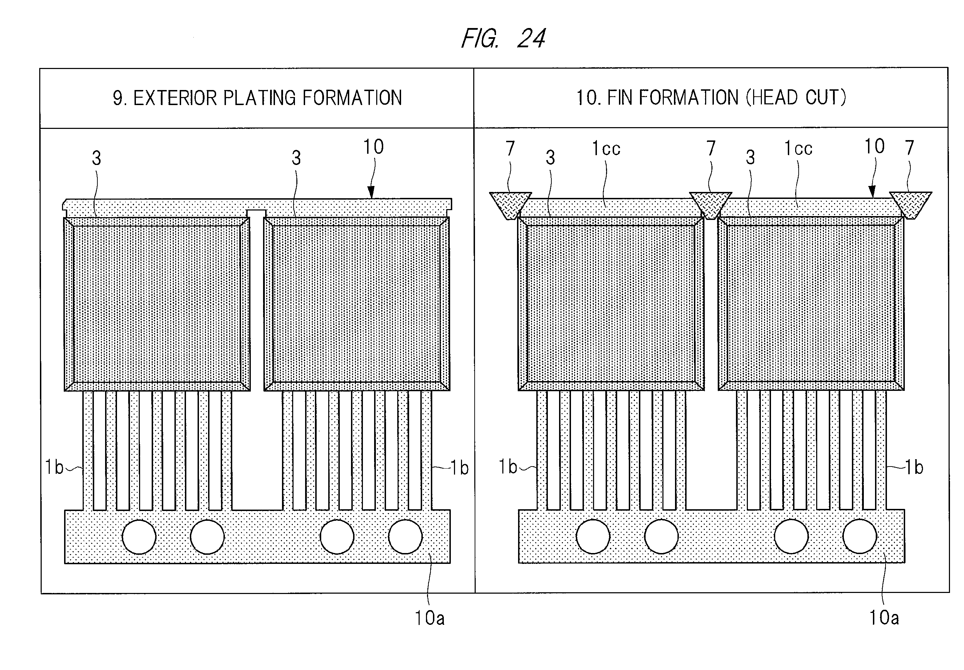

In the exterior plating formation process, as illustrated in FIG. 24, a plating film such as a solder plating is formed on each surface of the plurality of outer lead portions 1b, and the protruding portion 1cc or the bottom surface 1cb of the chip mounting portion 1c illustrated in FIG. 3.

### 10. Fin Formation (Head Cut)

After the exterior plating formation, a fin formation (head cut) illustrated in FIG. 19 is performed.

In the fin formation (head cut) process, as illustrated in FIG. 24, the adjacent protruding portions (fins) 1cc are separated from each other by punching between the protruding portions (fins) 1cc of the adjacent chip mounting portions 1c illustrated in FIG. 3 by the punch 7.

### 11. Lead Cut/Lead Forming

After the fin formation, a lead cut/lead forming illustrated in FIG. 19 is performed.

In the lead cut/lead forming process, first, as illustrated in FIGS. 25 and 26, the outer lead portions 1b are separated from the frame portion 10a of the lead frame 10 by cutting the outer lead portions 1b by the punch 7 (first lead cut). Next, the bending forming is performed on each of the outer lead portions 1b by the punch 7 and the die 8. That is, as illustrated in FIG. 26, the first bent portion 1bc and the second bent portion 1bd are formed with respect to each of the outer lead portions 1b (lead forming).

At this time, as illustrated in FIG. 7, it is preferable that the bent portions 1bc and 1bd are formed such that θ in the bending angle (θ + 90°) of the first bent portion 1bc is 0 < θ ≤ 6°.

Next, as illustrated in FIG. 27, the front end side of the outer lead portion 1b is cut in a predetermined amount by the punch 7, so that the outer lead portion 1b is formed to be short (second lead cut).

At this time, as illustrated in FIG. 7, the front end side of the outer lead portion 1b is cut such that the distance L2 between the third intersecting portion 1h and the fourth intersecting portion 1i of the outer lead portion 1b is shorter than the distance L1 between the first intersecting portion If and the second intersecting portion 1g of the outer lead portion 1b (L1 > L2).

Then, in the manufacturing method of the present embodiment, the second lead cut that forms each of the outer lead portions 1b to be short is performed after the lead forming (bending forming of the lead 1). That is, after the lead forming is performed, the second lead cut of each of the outer lead portions 1b is performed.

Therefore, the workability of the lead forming can be stabilized. Furthermore, it is possible to stabilize the coplanarity of each of the outer lead portions 1b. That is, in the present embodiment, in order to stabilize the workability of the lead forming and the coplanarity of the outer lead portions 1b, the lead cut is performed at two steps, that is, the first lead cut and the second lead cut.

The fragmentation of the power transistor 5 is completed by the lead cut/lead forming.

### 12. Sorting/Seal/Taping

After the lead cut/lead forming, a sorting/seal/taping illustrated in FIG. 19 is performed.

In the sorting/seal/taping process, as illustrated in FIG. 25, first, an electrical test of the power transistor 5 is performed by using a test 13. Next, a desired mark (seal) 11 is formed on the top surface 3a of the sealing body 3. The mark 11 is, for example, a type or a model number of a product, and the mark 11 is formed by laser irradiation or the like.

In this way, the assembling of the power transistor 5 is completed.

Next, the power transistor 5 is taped, packed, and shipped.

According to the semiconductor device (power transistor 5) of the present embodiment, as illustrated in FIG. 7, the distance (length) L2 between the third intersecting portion 1h and the fourth intersecting portion 1i of the outer lead portion 1b is formed to be shorter than the distance (length) L1 between the first intersecting portion If and the second intersecting portion 1g of the outer lead portion 1b (L1 > L2).

That is, in order to sufficiently secure the length L2, the length L1 is minimized to obtain the relationship of L1 > L2. Therefore, the mounting area of the power transistor 5 can be reduced by shortening the lead length, while securing the mounting strength of the power transistor 5.

Furthermore, in order to sufficiently secure the length L2, θ in the bending angle (θ + 90°) in the first bent portion 1bc of the outer lead portion 1b of the power transistor 5 is reduced to the possible extent.

θ in the bending angle of the first bent portion 1bc of the outer lead portion 1b is set to 6° or less (0 < θ ≤ 6°), while forming the portion of the length L1 of the outer lead portion 1b to be short in a possible range. As a result, the portion (the second portion 1bf) disposed in the thickness direction 3e of the sealing body 3 of the outer lead portion 1b can be set to an angle close to a right angle. Thus, the portion of the length L2 is lengthened in a possible range.

Therefore, it is possible to secure the mounting strength of the power transistor 5.

That is, the power transistor 5 of the present embodiment has a relationship of the length L1 > the length L2 and sets θ in the bending angle of the first bent portion 1bc of the outer lead portion 1b to 0 < θ ≤ 6°. As a result, the mounting area of the power transistor 5 can be reduced, while maintaining the mounting strength by sufficiently securing the length L2.

Therefore, the power transistor 5 of the present embodiment can realize a stable forming (bending forming) of the outer lead portion 1b, secure the mounting strength with respect to the mounting substrate 12 illustrated in FIG. 11, and reduce the mounting area of the power transistor 5.

In addition, in other words, it is possible to reduce the size of the power transistor 5.

### <Mechanically and Electrically Integrated Structure>

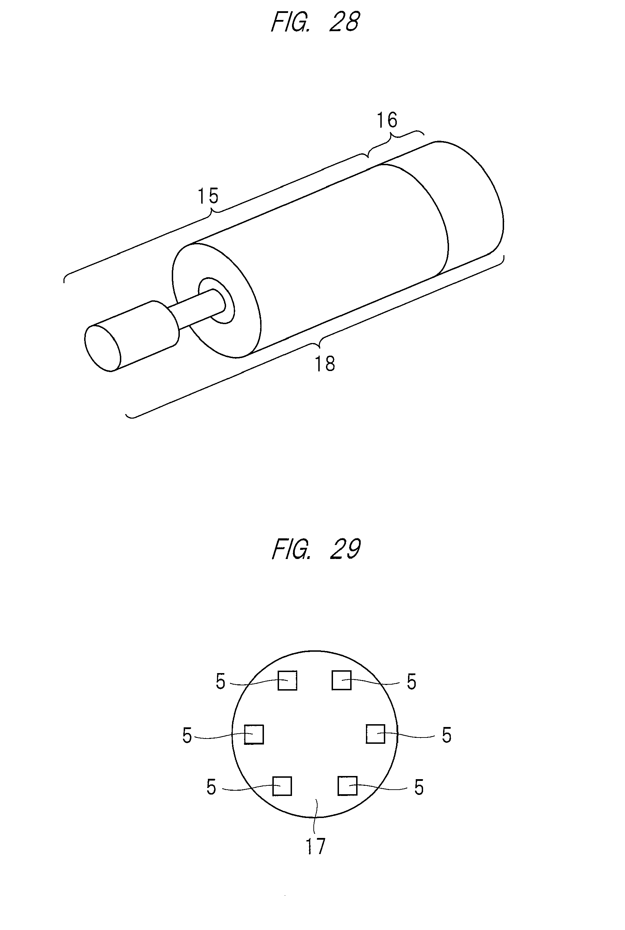

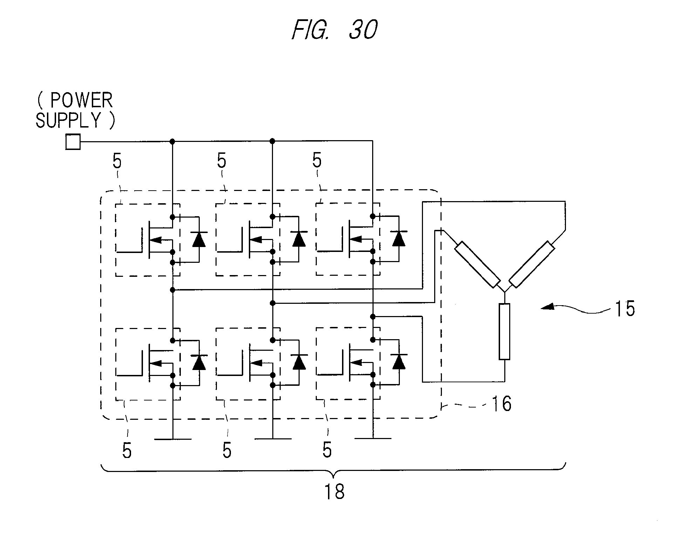

FIG. 28 is a perspective view illustrating an example of a structure of a mechanically and electrically integrated module of an embodiment, FIG. 29 is a plan view illustrating an example of an internal structure of an inverter unit in the mechanically and electrically integrated module of FIG. 28, and FIG. 30 is a circuit block diagram illustrating an example of a circuit configuration of the mechanically and electrically integrated module of FIG. 28.

For example, a mechanical and electrical integration is performed so as to realize the size reduction of the product, the weight reduction by the component reduction, the improvement of the electrical efficiency, and the like. However, in general, the mechanically and electrically integrated structure (mechanically and electrically integrated module) is a structure in which an electronic control device is directly mounted or embedded in a mechanical component.

As illustrated in FIGS. 28 and 29, in the mechanically and electrically integrated structure (the mechanically and electrically integrated module 18) used in an electric vehicle or the like, a motor unit (for example, a device mounted with a three-phase motor) 15 and an inverter unit (inverter device) 16 converting DC power externally supplied into AC power and supplying the AC power to the motor unit 15 are integrated. The mounting substrate 17 as illustrated in FIG. 29 is mounted on the inside of the inverter unit 16, and at least two or more semiconductor devices (for example, six semiconductor devices) 5 are mounted on the mounting substrate 17. The semiconductor device 5 corresponds to a power MOSFET in the circuit configuration of FIG. 30.

Since such a mounting substrate 17 is mounted on the inside of the inverter unit 16, the size of the mounting substrate 17 is small. Furthermore, since the mounting substrate 17 is close to the motor unit 15, the mounting substrate 17 has to withstand high temperature and high vibration.

Therefore, the semiconductor device 5, which is mounted on the mounting substrate 17 in the inverter unit 16, has to achieve the size reduction and have high reliability.

Therefore, even in the semiconductor device 5, as in the above-described power transistor 5, the distance L2 between the third intersecting portion 1h and the fourth intersecting portion 1i of the outer lead portion 1b illustrated in FIG. 7 is formed to be shorter than the distance L1 between the first intersecting portion If and the second intersecting portion 1g of the outer lead portion 1b (L1 > L2). θ in the bending angle (θ + 90°) of the first bent portion 1bc of the outer lead portion 1b is set to 0 < θ ≤ 6°.

Furthermore, the bottom surface of the die pad (chip mounting portion) is configured so as to be exposed from the bottom surface of the sealing body, and the die pad is configured so as to be protruded on the side surface of the sealing body.

Therefore, even in the mechanically and electrically integrated module 18, it is possible to achieve the size reduction of the semiconductor device 5 mounted thereon, and further obtain the high reliability.

### <Modification Examples>

In the foregoing, the invention made by the inventors of the present invention has been concretely described based on the embodiments. However, it is needless to say that the present invention is not limited to the foregoing embodiments and various modifications and alterations can be made within the scope of the present invention.

### (Modification Example 1)

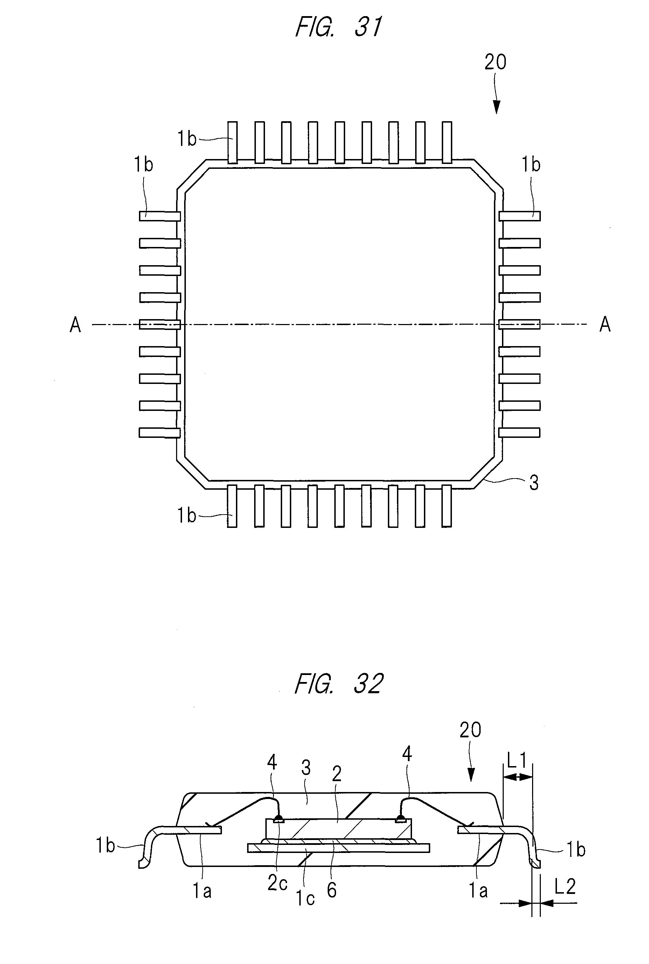

In the above-described embodiment, the case of the semiconductor device having the structure in which the plurality of outer lead portions 1b protrude from the side surface of one side of the sealing body 3 has been described, but the semiconductor device may be, for example, a quad flat package (QFP) 20 illustrated in FIGS. 31 and 32.

FIG. 31 is a plan view illustrating a structure of a semiconductor device of the modification example of the embodiment, and FIG. 32 is a cross-sectional view illustrating a structure cut out along line A-A of FIG. 31.

That is, the semiconductor device of the present embodiment may be the QFP 20 illustrated in FIGS. 31 and 32. At this time, as in the shape of the outer lead portion 1b illustrated in FIG. 7, the distance (length) L2 between the third intersecting portion 1h and the fourth intersecting portion 1i of the outer lead portion 1b needs to be formed to be shorter than the distance (length) L1 between the first intersecting portion If and the second intersecting portion 1g of the outer lead portion 1b (L1 > L2). In addition, even in the QFP 20, it is preferable that θ in the bending angle of the first bent portion 1bc of the outer lead portion 1b is set to 0 < θ ≤ 6°.

The semiconductor device may be a small outline package (SOP) as long as the SOP has the outer lead portion 1b whose shape is the same as the shape of the outer lead portion 1b illustrated in FIG. 7.

### (Modification Example 2)

The case where the solder of the plating film formed in the exterior plating process of the embodiment, the solder being an example of the die bond material 6, or the solder 9 used for solder bonding upon mounting of the semiconductor device is the lead-free solder that does not substantially contain lead (Pb) has been described, but the solder may be a solder containing lead. However, considering the environmental contamination problem, the use of the lead-free solder is preferable.

Here, the lead-free solder means a solder in which the content of lead (Pb) is 0.1 wt% or less. This content is defined as a standard of Restriction of Hazardous Substances (RoHS) Directive.

### (Modification Example 3)

Furthermore, a combination of the modification examples can be applied without departing from the gist of the technical ideas described in the embodiments.

## Claims

1. A semiconductor device comprising:
a chip mounting portion having a first surface, and a second surface on an opposite side of the first surface;
a semiconductor chip having a principal surface, a first electrode pad formed in the principal surface, a rear surface on an opposite side of the principal surface, and a second electrode pad formed in the rear surface, the semiconductor chip being mounted on the first surface of the chip mounting portion through a die bond material such that the rear surface faces the first surface of the chip mounting portion;
a lead electrically connected to the first electrode pad through a conductive member; and
a sealing body having a third surface, a fourth surface on an opposite side of the third surface, a first side surface disposed between the third surface and the fourth surface in a thickness direction of the semiconductor chip, and a second side surface on an opposite side of the first side surface, and sealing the semiconductor chip, a part of the chip mounting portion, and the conductive member such that the second surface of the chip mounting portion is exposed,
wherein the other part of the chip mounting portion protrudes from the first side surface of the sealing body,
the lead includes an inner lead portion covered with the sealing body, and an outer lead portion exposed from the sealing body,
the outer lead portion of the lead includes a first portion protruding from the second side surface of the sealing body in a first direction, a second portion extending in a second direction intersecting with the first direction, and a third portion extending in a third direction intersecting with the second direction, and
a length of the third portion in the third direction is shorter than a length of the first portion in the first direction.

2. The semiconductor device according to claim 1,
wherein a position that protrudes from the second side surface of the sealing body of the outer lead portion is closer to the third surface of the sealing body than the fourth surface of the sealing body in a thickness direction of the sealing body.

3. The semiconductor device according to claim 1,
wherein the second portion is connected to the first portion through a first bent portion,
the third portion is connected to the second portion through a second bent portion,
a length of the first portion is a length from the second side surface of the sealing body to the first bent portion, and
a length of the third portion is a length from a front end of the outer lead portion to the second bent portion.

4. The semiconductor device according to claim 1,
wherein the first portion, the second portion, and the third portion are linearly extending portions.

5. The semiconductor device according to claim 1,
wherein the first bent portion is a portion bent from the first direction toward the second direction, and
the second bent portion is a portion bent from the second direction toward the third direction.

6. The semiconductor device according to claim 1,
wherein the first direction and the third direction are directions parallel to the third surface of the sealing body.

7. The semiconductor device according to claim 1,
wherein the conductive member includes a first wire, and a second wire thinner than the first wire.

8. The semiconductor device according to claim 7,
wherein the first electrode pad includes a first pad, and a second pad having a smaller size than the first pad when seen in a plan view,
the first wire is provided in plurality and is electrically connected to the first pad, and
the second wire is electrically connected to the second pad.

9. A semiconductor device comprising:
a chip mounting portion having a first surface, and a second surface on an opposite side of the first surface;
a semiconductor chip having a principal surface, a first electrode pad formed in the principal surface, a rear surface on an opposite side of the principal surface, and a second electrode pad formed in the rear surface, the semiconductor chip being mounted on the first surface of the chip mounting portion through a die bond material such that the rear surface faces the first surface of the chip mounting portion;
a lead electrically connected to the first electrode pad through a conductive member; and
a sealing body having a third surface, a fourth surface on an opposite side of the third surface, a first side surface disposed between the third surface and the fourth surface in a thickness direction of the semiconductor chip, and a second side surface on an opposite side of the first side surface, and sealing the semiconductor chip, a part of the chip mounting portion, and the conductive member such that the second surface of the chip mounting portion is exposed,
wherein the other part of the chip mounting portion protrudes from the first side surface of the sealing body,
the lead includes an inner lead portion covered with the sealing body, and an outer lead portion exposed from the sealing body,
the outer lead portion of the lead includes a first portion, a second portion, and a third portion,
the first portion of the outer lead portion has a first front end surface connected to the second side surface of the sealing body,
the second portion of the outer lead portion is disposed between the first portion and the third portion of the outer lead portion,
the third portion of the outer lead portion has a second front end surface disposed on an opposite side of the first front end surface,
a length from a first intersecting portion between a first virtual line of the first portion and the first front end surface to a second intersecting portion between an extension line of the first virtual line of the first portion and an extension line of a second virtual line of the second portion is longer than a length from a third intersecting portion between an extension line of a third virtual line of the third portion and an extension line of the second virtual line of the second portion to a fourth intersecting portion between the third virtual line of the third portion and the second front end surface,
the first virtual line is a line that passes through a center of the first portion in a thickness direction and extends in parallel to a surface of the first portion,
the second virtual line is a line that passes through a center of the second portion in a thickness direction and extends in parallel to a surface of the second portion, and
the third virtual line is a line that passes through a center of the third portion in a thickness direction and extends in parallel to a surface of the third portion.

10. The semiconductor device according to claim 9,
wherein a position that protrudes from the second side surface of the sealing body of the outer lead portion is closer to the third surface of the sealing body than the fourth surface of the sealing body in a thickness direction of the sealing body.

11. The semiconductor device according to claim 9,
wherein an angle formed by a fourth virtual line extending in parallel to a thickness direction of the sealing body and the second virtual line is 6° or less.

12. The semiconductor device according to claim 9,
wherein each of the first virtual line and the third virtual line is parallel to the third surface of the sealing body.

13. The semiconductor device according to claim 9,
wherein the conductive member includes a first wire, and a second wire thinner than the first wire.

14. The semiconductor device according to claim 13,
wherein the first electrode pad includes a first pad, and a second pad having a smaller size than the first pad when seen in a plan view,
the first wire is provided in plurality and is electrically connected to the first pad, and
the second wire is electrically connected to the second pad.
